# EUROPÄISCHE PATENTSCHRIFT

(11) **EP 0 712 131 B1**
(45) Veröffentlichungstag und Bekanntmachung des Hinweises auf die Patenterteilung: **10.02.1999**
(21) Anmeldenummer: 95113882.5
(22) Anmeldetag: 05.09.1995
(51) Int. Cl.: G11C 7/00, H04M 3/50

(54) **Vorrichtung zur Sprachaufzeichnung mit anschliessender Texterstellung**
Voice recorder and corresponding text generator
Dispositif d'enregistrement de parole avec établissement d'un texte correspondant

(30) Priorität: 24.09.1994 DE 4434255
(43) Veröffentlichungstag der Anmeldung: 15.05.1996
(73) Patentinhaber: ALCATEL ALSTHOM COMPAGNIE GENERALE D'ELECTRICITE, 75008 Paris (FR)
(72) Erfinder: Kopp, Dieter, D-71282 Hemmingen (DE); Hackbarth, Heidi, Dr., D-70825 Korntal (DE)
(74) Vertreter: Knecht, Ulrich Karl, Dipl.-Ing.

(56) Entgegenhaltungen:
- EP-A- 0 092 084
- EP-A- 0 294 202
- EP-A- 0 299 711
- EP-A- 0 337 086
- FR-A- 2 639 741
- FR-A- 2 692 710
- US-A- 5 051 924

## Beschreibung

Die Erfindung betrifft eine Vorrichtung und ein Verfahren zur Sprachaufzeichnung für eine anschließender Texterstellung.

Aus dem Stand der Technik sind Diktiergeräte bekannt, die als Speichermedium Tonbandkassetten, sogenannte "Microtapes" verwenden. Diese Diktiergeräte bieten die bekannten Bedienfunktionen wie z.B. "Aufzeichnen", "Vorspulen", "Rückspulen" und "Wiedergabe", die zur späteren Erstellung eines Textes und auch zur Korrektur während der Aufaufnahme verwendet werden ("Taschengeräte"; Diktaphone, The voice of business; Firmenprospekt).

Desweiteren sind aus dem Stand der Technik sogenannte Telekooperations- und Mehrwertdienste bekannt. Darunter versteht man, daß diverse Auftraggeber A, B, C mittels Sprache über ein Telefon ein Dienstleistungsunternehmen anrufen, ein Diktat diktieren, das Dienstleistungsunternehmen aus diesem Diktat ein Text erstellt und mittel beispielsweise eines E-mails den fertigen Text an den Auftraggeber zurücksendet. Der Dienstleistungsunternehmer kann hierfür entweder über eigene Schreibkräfte im Hause oder über z.B. Teilzeitkräfte in Heimarbeit verfügen. Geschrieben wird auf Text-PC's. Eine Vergütung des Dienstes kann unter anderem über spezielle "Schreibdienst-Gebühreneinheiten" belastet werden (Philips Diktiersysteme; "Schreibdienste über Telefon"; Januar 1994).

Mit fortlaufender Verbesserung heutiger Spracherkennungssysteme, existieren mittlerweise Sprachsysteme, die auf eine Spracheingabe eine automatische Textausgabe folgen lassen. Der Text wird von einem Benutzer eingesprochen, woraufhin eine akustische Analyse der gesprochenen Sprache erfolgt. Nach der Analyse wird die gesprochene Sprache auf ein Vergleichssystem gegeben, welche die gesprochene Sprache mit einem im Lexikon existierenden Phonembestand vergleicht. Daraus wird dann eine erkannte Wortfolge ermittelt. Die so erkannten Worte werden direkt in einen Text umgesetzt. Hierbei treten alle Schwierigkeiten auf, die bei einem bisher bekannten Spracherkennungssystem auftreten können. Zusätzlich muß noch erwähnt werden, daß dieses System ungeeignet ist, Sprache von diesen sogenannten Minikassetten zu verarbeiten, da die Qualität nicht den Anforderungen für ein Spracherkennungssystem entspricht ("Spracheingabe-Textausgabe", Philips Research Topics, Nr. 3; September 1993).

Alle vorgenannten Systeme bieten Nachteile, wie z.B. die verhältnismäßig geringe Kompaktheit bei Verwendung der Tonbandkassetten, oder die geringe Flexibilität von Ort und Zeit bei Verwendung des Diktiersystems, oder aber die Nichtverwendbarkeit von Tonbandkassetten für bekannte Spracherkennungssysteme.

Aus der Patentschrift US 5 051 924 ist ein System zur Erstellung eines Textes aus Sprachsignalen bekannt. Sprache wird mittels eines Telefones aufgesprochen und unverarbeitet über eine Telefonleitung an ein Spracherkennungssystem übertragen. Dort erfolgt die Generierung eines zu der Sprache korrespondierenden Textes. Bei der Spracherkennung handelt es sich um sprecherabhängige Spracherkennung, d.h. das Spracherkennungssytem benutzt Sprachreferenzen jedes einzelnen Benutzers. Das System hat den Nachteil, daß über eine Telefonleitung übertragene Sprachsignale niedrige Qualität haben, da über Telefonleitungen nur ein beschränktes Frequenzband übertragen werden kann (300 - 3400 Hz). Daher ist ein solches System nicht für sprecherunabhängige Spracherkennung geeignet.

Daraus ergibt sich die Aufgabe, eine Vorrichtung und ein Verfahren zu schaffen, welches digital arbeitet und universell einsetzbar ist.

Diese Aufgabe wird erfindungsgemäß gelöst durch die Merkmale des Patentanspruchs 1 und durch die Merkmale des Patentanspruchs 6.

Vorteilhaft bei dem hier beschriebenen Verfahren und der entsprechenden Vorrichtung ist, daß eine zeitliche und räumliche Trennung zwischen der Aufnahme mit einer Vorverarbeitung und einem Vergleich zur Texterstellung gewährleistet ist. Durch die Vorverarbeitung steht für ein Sprachverarbeitungssystem eine optimal vorverarbeitete Sprache zur Erkennung zur Verfügung. Weiterhin vorteilhaft ist, daß das digitale Diktiergerät sehr kompakt und klein ausgebildet werden kann. Durch Verwendung eines digitalen Speichers anstelle einer Tonbandkassette entfällt die Ausbildung eines großen Laufwerks.

Weitere vorteilhafte Ausgestaltungen sind den Patentansprüchen 2 bis 5 und dem Patentanspruch 7 zu entnehmen.

Nach Patentanspruch 2 ist es vorteilhaft, daß durch eine zusätzliche Codierung eine Datenreduktion vorgenommen wird. Dies ist vorteilhaft für die Abspeicherung, weil dazu weniger Speicherbedarf benötigt wird und die Vorrichtung somit kleiner und billiger wird.

Im folgenden wird anhand der Figuren die Erfindung näher erläutert. Folgende Figuren zeigen:
- Fig. 1: eine erfindungsgemäße Vorrichtung zur Sprachaufzeichnung,
- Fig. 2: eine erfindungsgemäße Einrichtung zur Sprachaufzeichnung in Kartenformat,
- Fig. 3: ein Ablaufdiagramm des erfindungsgemäßen Verfahrens nach Anspruch 5,
- Fig. 4a: Draufsicht auf eine erfindungsgemäße Vorrichtung in Kartenformat,
- Fig. 4b: Unteransicht einer erfindungsgemäßen Vorrichtung in Kartenformat.

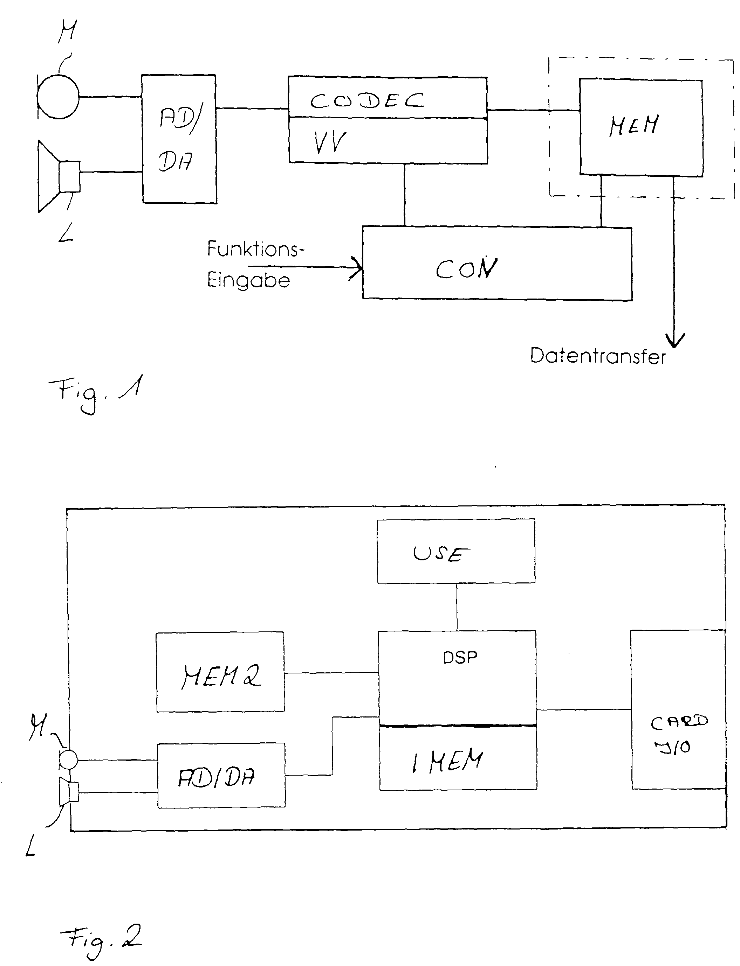

Im folgenden wird die Vorrichtung anhand von Fig. 1 näher erläutert.

Die erfindungsgemäße Vorrichtung besteht aus einem akustischen Eingabemittel M, hier einem Mikrofon. Über das Mikrofon M wird analoge Sprache eingesprochen. Diese wird auf einen Analog/Digital-Digital/Analog-Wandler AD/DA gegeben, in dem die Sprache digitalisiert wird. Die digitalisierte Sprache wird auf Mittel zur Vorverarbeitung VV gegeben. Die Vorverarbeitung erfolgt in Form einer Merkmalsextraktion. Hierbei werden beispielsweise spektrale Komponenten extrahiert. Die so digitalisierte vorverarbeitete Sprache wird in einem Speicher MEM abgespeichert.

Desweiteren besteht die erfindungsgemäße Vorrichtung zur Sprachaufzeichnung noch aus einer Steuerungsvorrichtung CON. Über die Steuerungsvorrichtung CON werden Bedienfunktionen eingegeben. Diese Bedienfunktionen können beispielsweise Vorlauf und Rücklauf sein, oder aber eine Wiedergabe oder eine Aufzeichnungsfunktion. Die Steuerungsvorrichtung CON wirkt entsprechend der speziellen Bedienfunktionseingabe entweder auf die Mittel zur Vorverarbeitung VV oder aber auf den Speicher MEM.

Zur Wiedergabe der bereits aufgezeichneten Sprache muß jeweils, z.B. über die Steuerungsvorrichtung CON, aus dem Speicher MEM die bereits abgespeicherte Sprache wiederum auf die Mittel zur Vorverarbeitung VV gegeben werden, von dort aus über den Analog/Digital-Digital/Analog-Wandler AD/DA in analoge Form umgewandelt werden und über ein akustisches Ausgabemittel L, hierbei ein Lautsprecher, wiedergegeben werden.

Desweiteren kann die Vorrichtung zur Sprachaufzeichnung zusätzlich ein Codierer/Decodierer CODEC aufweisen. In dem Codierer/Decodierer CODEC wird entweder die bereits digitalisierte Sprache codiert und dann ebenfalls in dem Speicher MEM abgespeichert oder aber beim Wiederaufsagen der bereits abgespeicherten Sprache wieder decodiert. Die solcher art decodierte Sprache wird über den Analog/Digital-Digital/Analog-Wandler wieder in eine analoge Form umgesetzt und über den Lautsprecher L ausgegeben. Mittels dieser Codierung erfolgt eine Datenreduktion.

Als Speicher kann wahlweise ein EEPROM verwendet werden oder aber eine PCMCIA-Karte. Die PCMCIA-Karte ist herausnehmbar und kann, als Speicher der vorab aufgesprochenen Sprache, mit sich mitgetragen werden. Der andere nicht flüchtige Speicher EEPROM ist fest in der Vorrichtung installiert. Eine Übertragung der darin abgespeicherten Sprachdaten kann mittels Datentransfer über beispielsweise ein Telefonnetz zu einem Datenverarbeitungsendgerät erfolgen. Als weitere Möglichkeit steht hier zur Verfügung, daß ein Datentransfer über ein GSM-Netz erfolgt. Somit ergibt sich, daß Sprache an einem Ort und einer Stelle aufgezeichnet wird und mittels eines Mobilfunknetzes oder eines konventionellen Telefonnetzes übertragen wird und an einem anderen Ort in einen Text umgewandelt wird. Die Umwandlung der Sprachdaten in einen Text kann auf zwei Arten erfolgen:
1. Die abgespeicherten Sprachdaten werden wieder aufbereitet und als Sprache ausgegeben, und die so wieder akustisch umgewandelten Sprachdaten werden, z.B. von einer Sekretärin abgehört und in einen Text umgewandelt.
2. Die abgespeicherten Sprachdaten werden automatisch mittels eines Spracherkennungssystems in einen Text umgewandelt. Dazu können bereits bekannte Spracherkennungssysteme verwendet werden, die mittels eines Mustervergleichs mit bekannten Mustern von Worten die abgespeicherte Sprache in einen Text umwandeln. Die codierte abgespeicherte Sprache dient hierbei nur zu Korrekturzwecken. Der automatisch erstellte Text wird mit den vorab codiert abgespeicherten Sprachdaten die wieder aufgesprochen werden, verglichen. Somit ist ein grundlegend falsch erkanntes Wort sofort identifizierbar.

Im folgenden wird anhand von Fig. 2 die Vorrichtung zur Sprachaufzeichnung in Kartenformat für eine anschließende Texterstellung näher erläutert. Die Vorrichtung zur Sprachaufzeichnung in Kartenformat besteht aus akustischen Ein- und Ausgabemittel M, L. Das akustische Eingabemittel M ist ein Mikrofon und das akustische Ausgabemittel L ein Lautsprecher. Sprache wird über die akustischen Eingabemittel M auf einen Analog/Digital-Digital/Analog-Wandler AD/DA gegeben und dort digitalisiert. Die digitalisierte Sprache wird in einem digitalen Signalprozessor DSP weiterverarbeitet. Der digitale Signalprozessor DSP besitzt einen internen Speicher IMEM zur Speicherung von Programmen. Desweiteren ist an den digitalen Signalprozessor DSP ein weiterer Speicher MEM2 angeschlossen. Mit dem digitalen Signalprozessor DSP ebenfalls verbunden, besteht die Vorrichtung aus einen Bedienteil USE bestehend aus Bedienelementen zum Auslösen von Bedienfunktionen und aus einer Kartenschnittstelle CARD I/O zum Anschluß an ein Datenverarbeitungsendgerät z.B. einen PC, oder ein Sprachverarbeitungssystem. Die Kartenschnittstelle CARD I/O kann beispielsweise eine PCMCIA-Kartenschnittstelle sein. Die Bedienelemente des Bedienteils USE können beispielsweise aus einer Folientastatur oder aber aus Drucktasten bestehen.

Die hier beschriebene Vorrichtung in Form einer Karte besitzt ebenfalls die Bedienfunktionen, wie sie bei einem Standarddiktiergerät bekannt sind. Zur Ausgabe von bereits vorab gespeicherter Sprache befindet sich auf der Karte ebenfalls ein akustisches Ausgabemittel, hier in Form eines Lautsprechers.

Als mögliches Ausführungsbeispiel der Vorrichtung in Kartenformat, kann die Karte als digitalen Signalprozessor DSP beispielsweise einen sogenannten Low-Power-DSP beinhalten, als weiteren Speicher MEM2 einen 16 Mbit oder 32 Mbit Nand EEprom darstellen. Die in dem weiteren Speicher MEM2 abgespeicherten Daten werden in Abhängigkeit von der Weiterverarbeitung zur Texterstellung in einem Datenverarbeitungsendgerät entweder PCM oder ADPCM oder GSM oder mit 4,8 kbit/s codiert.

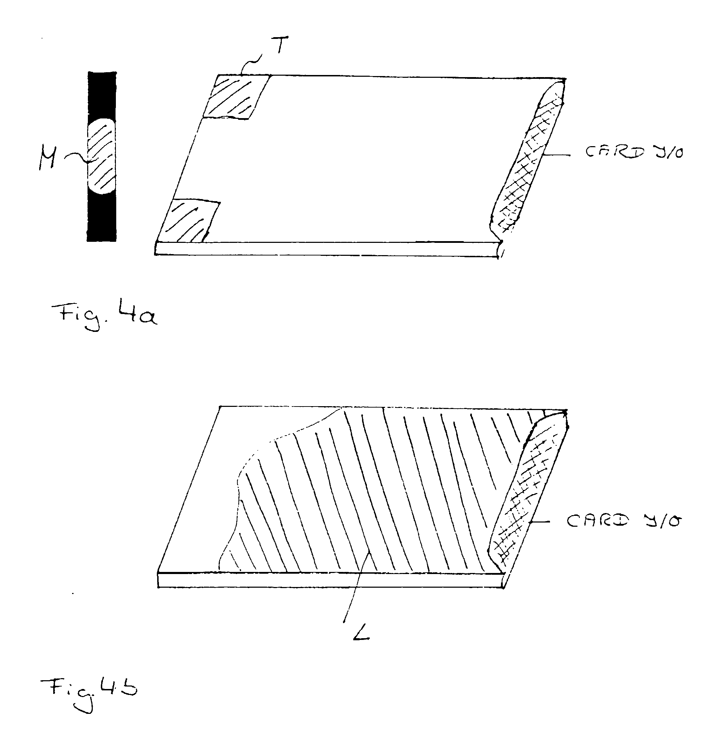

Im folgenden wird anhand der Fig. 4a und 4b eine mögliche Ausführungsform der Vorrichtung in Kartenformat näher erläutert.

Fig. 4a zeigt eine Draufsicht auf eine erfindungsgemäße Karte. Auf der Oberfläche befinden sich sogenannte Drucktasten oder aber eine Folientastatur. An dem Einschubende der Karte befindet sich die Kartenschnittstelle CARD I/O. Aus praktischen Gründen, könnte das Mikrofon M in dem Einschubende entgegengesetzten gelegenen oberen Steg der Karte eingelegt sein, was eine praktische Handhabbarkeit beinhalten würde. Wie die Unteransicht in Fig. 4b zeigt, ist der Lautsprecher ein z.B. sogenannter Flächenlautsprecher. Die in den Fig. 4a und 4b gezeigte Anordnung stellt eine sehr praktisch handhabbare Möglichkeit dar.

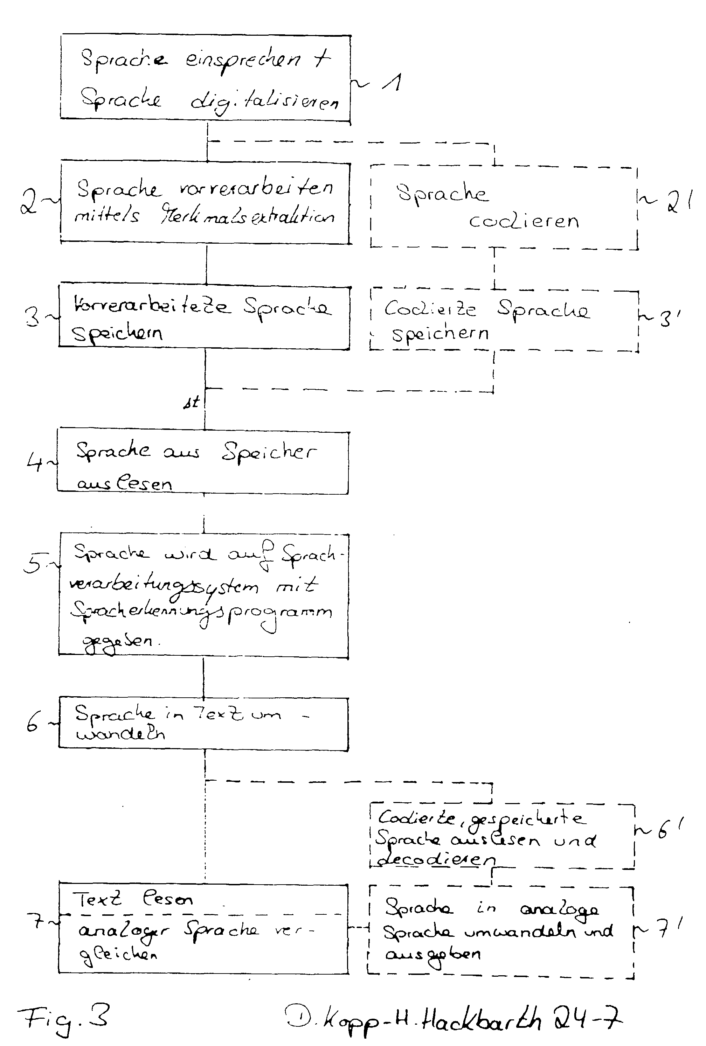

Im folgenden wird anhand von Fig. 3 ein Verfahren zur Sprachaufzeichnung mit anschließender Texterstellung mittels eines Sprachverarbeitungssystems näher erläutert. Bei dem Verfahren wird in einem ersten Schritt 1 Sprache eingesprochen und die eingesprochene Sprache wird digitalisiert. In einem weiteren Schritt 2 erfolgt eine Vorverarbeitung der Sprache in Form einer Merkmalsextraktion. In einem dritten Schritt 3 wird die digitalisierte, vorverarbeitete Sprache gespeichert.

Beispielsweise zu einem anderen Zeitpunkt Δt wird die digitalisierte vorverarbeitete Sprache aus dem Speicher wieder ausgelesen 4. In einem nächsten Schritt 5 wird die Sprache auf ein Spracherkennungssystem mit einem Spracherkennungsprogramm gegeben. Das Sprachverarbeitungssystem mit dem Spracherkennungsprogramm führt ein Mustervergleich mit in Referenzspeichern abgelegten Worten durch. Die hier erwähnten Sprachverarbeitungssysteme sind aus dem Stand der Technik hinlänglich bekannt (siehe Würdigung des Standes der Technik). In einem weiteren Schritt 6 wird somit die eingesprochene Sprache in einen Text umgewandelt.

Zusätzlich kann die in dem ersten Schritt eingesprochene und digitalisierte Sprache in einem Schritt 2' noch codiert werden. Hierzu kann beispielsweise ein sogeannter Low-Bit-Rate Codec mit 4,8 kbit verwendet werden oder aber für GSM mit 13 kbit. Die codierte Sprache kann in einem weiteren Schritt 3' parallel zu Schritt 3 gespeichert werden. Die solcher Art codierte und abgespeicherte Sprache stellt im Falle eines notwendigen Korrekturlesens eine bessere Möglichkeit der Korrektur dar. Die in dem 6ten Schritt 6 in Text umgewandelte Sprache wird einem Benutzer als Textfile vorgelegt und, um eine einfache Korrektur zu ermöglichen, kann die codierte Sprache wieder decodiert 6' werden in analoge Sprache umgewandelt und ausgegeben werden 7' und im direkten Vergleich mit dem gelesenen Text verglichen werden. Somit steht einem Benutzer ein direkter Vergleich zwischen erkanntem Wort in Textfunktion und dem wirklich aufgesprochenen Text zur Verfügung.

## Patentansprüche

1. Vorrichtung zur Sprachaufzeichnung für eine anschließende Texterstellung, mit
- akustischen Ein- und Ausgabemitteln (L, M) zum Einsprechen und Ausgeben von gesprochener Sprache,
- einem Analog/Digital-Digital/Analog-Wandler (AD/DA) zum Digitalisieren der eingesprochenen Sprache und zum Umwandeln der digitalisierten Sprache in analoge Sprache,
- Vorverarbeitungsmitteln (VV), zum Vorverarbeiten der digitalisierten Sprache in Form einer für Spracherkennung geeigneten Merkmalsextraktion,
- einem Speicher (MEM) zum Speichern der digitalisierten, vorverarbeiteten Sprache,
- einer Steuerungsvorrichtung (CON), die eine Ausführung eingegebener Bedienfunktionen an den Vorverarbeitungsmitteln (W) und/oder an dem Speicher (MEM) steuert und deren Funktion auslöst, und
- Übertragungsmitteln zur Übertragung der Daten des Speichers (MEM) mittels eines Datentransfers über ein Telefonnetz oder ein Mobilfunknetz zu einem Sprachverarbeitungssystem, in dem eine Erstellung eines zu der Sprache korrespondierenden Textes erfolgt.

2. Vorrichtung zur Sprachaufzeichnung nach Anspruch 1, mit einem Codierer/Decodierer (CODEC), bei der die digitalisierte Sprache zusätzlich in dem Codierer/Decodierer (CODEC) codiert wird und in dem Speicher (MEM) abgespeichert wird.

3. Vorrichtung nach Anspruch 1 oder 2, bei der der Speicher (MEM) ein nicht flüchtiger Schreib-/Lesespeicher ist, insbesondere ein EEPROM, oder bei der der Speicher (MEM) ein herausnehmbarer Speicher, insbesondere eine PCMCIA-Karte, ist.

4. Vorrichtung zur Sprachaufzeichnung nach Anspruch 1 in Kartenformat.

5. Vorrichtung zur Sprachaufzeichnung nach Anspruch 4, bei der das akustische Ausgabemittel (L) ein Flächen lautsprecher ist, bei der die Steuerungsvorrichtung ein aus Bedienelementen (T) bestehendes Bedienteil (USE) ist, und bei der die Bedienelemente (T) eine Folientastatur oder Drucktasten sind.

6. Verfahren zur Sprachaufzeichnung für anschließende Texterstellung, mit den folgenden Schritten:
- Einsprechen von gesprochener Sprache mittels akustischer Ein- und Ausgabemittel,
- Digitalisieren (1) der eingesprochenen Sprache mittels eines Analog/Digital-Digital/Analog-Wandlers (AD/DA),
- Vorverarbeiten (2) der digitalisierten Sprache in Form einer für Spracherkennung geeigneten Merkmalsextraktion,
- Speichern (3) der digitalisierten, vorverarbeiteten Sprache in einem Speicher (MEM), und
- Auslesen (4) der Daten des Speichers (MEM) und Übertragen (5) der Daten des Speichers (MEM) mittels eines Datentransfers über ein Telefonnetz oder über ein Mobilfunknetz zu einem Sprachverarbeitungssystem, in dem eine Erstellung (6) eines zu der Sprache korrespondierenden Textes erfolgt.

7. Verfahren nach Anspruch 6, bei dem
- die digitalisierte Sprache parallel zur Vorverarbeitung codiert wird und ebenfalls abgespeichert wird, und
- nach der Umwandlung der digitalisierten, vorverarbeiteten Sprache in den Text, die codierte Sprache zur Durchführung einer Korrektur decodiert wird, und wieder in analoge Sprache umgewandelt wird, um dann in einem Vergleich zwischen automatisch erkanntem Text und der Sprache eine Korrektur durchgeführt wird.

## Claims

1. A device for recording speech for a subsequent text generation comprising
- acoustic input- and output means (L, M) for the input and output of spoken speech,
- an analogue/digital - digital/analogue converter (AD, DA) for digitizing the input speech and for converting the digitized speech into analogue speech,
- preprocessing means (VV) for pre-processing the digitized speech in the form of a feature extraction suitable for speech recognition,
- a memory (MEM) for storing the digitized, pre-processed speech,
- a control device (CON) which controls an implementation of input operating functions in the pre-processing means (VV) and/or in the memory (MEM) and triggers the function thereof and
- transmission means for transmitting the data from the memory (MEM) by data transfer via a telephone network or a mobile radio network to a speech processing system in which a generation of a text corresponding to the speech takes place.

2. A device for speech recording according to Claim 1 comprising a coder/decoder (CODEC) in which the digitized speech is additionally coded in the coder/decoder (CODEC) and is stored in the memory (MEM).

3. A device according to Claim 1 or 2, wherein the memory (MEM) is a non-volatile write/read memory, in particular an EEPROM, or in which the memory (MEM) is a removable memory, in particular a PCMCIA card.

4. A device for speech recording according to Claim 1 in card format.

5. A device for speech recording according to Claim 4 wherein the acoustic output means (L) is a surface loudspeaker, the control device is an operating component (USE) consisting of operating elements (T), and the operating elements (T) are a membrane keyboard or pushbuttons.

6. A process for speech recording for a subsequent text generation comprising the following steps:
- input of spoken speech by acoustic input- and output means,
- digitization (1) of the input speech by means of an analogue/digital - digital/analogue converter (AD/DA),
- pre-processing (2) of the digitized speech in the form of a feature extraction suitable for speech recognition,
- storage (3) of the digitized, pre-processed speech in a memory (MEM) and
- read-out (4) of the data from the memory (MEM) and transmission (5) of the data from the memory (MEM) by data transfer via a telephone network or a mobile radio network to a speech processing system in which a generation (6) of a text corresponding to the speech takes place.

7. A process according to Claim 6 wherein
- the digitized speech is coded in parallel with the pre-processing and is likewise stored and
- following the conversion of the digitized, pre-processed speech into the text, the coded speech is decoded for the implementation of a correction and is reconverted into analogue speech whereupon, in the form of a comparison between automatically recognised text and the speech, a correction is implemented.

## Revendications

1. Dispositif d'enregistrement de la voix pour une rédaction consécutive d'un texte correspondant, comprenant
- des dispositifs acoustiques d'entrée et de sortie (L, M), destinés à enregistrer et à émettre la voix enregistrée,
- un convertisseur analogique/numérique et numérique/analogique (AD/DA), destiné à numériser la voix enregistrée et à transformer la voix numérisée en voix analogique,
- des moyens de traitement préalable (VV), destinés à pré-traiter la voix numérisée à l'aide d'une extraction de ses caractéristiques, appropriée à une reconnaissance de la voix,
- une mémoire (MEM), destinée à stocker la voix numérisée et pré-traitée,
- un dispositif de commande (CON), destiné à transmettre vers les moyens de traitement préalables (VV) et/ou vers la mémoire (MEM) l'exécution des fonctions de commande entrées et à déclencher lesdites fonctions, et
- des moyens de transmission, destinés à transmettre les données de la mémoire (MEM) à l'aide d'un système de transfert de données, par le réseau téléphonique ou un réseau de téléphonie mobile, vers un système de traitement de la voix ou vers un terminal de traitement des données, dans lequel le texte correspondant à la voix sera rédigé.

2. Dispositif d'enregistrement de la voix selon la revendication 1, comprenant un codeur/décodeur (CODEC), dans lequel dispositif la voix numérisée est en plus codée dans un codeur/décodeur (CODEC) et stockée dans la mémoire (MEM).

3. Dispositif selon la revendication 1 ou 2, dans lequel dispositif la mémoire (MEM) est une mémoire non volatile pour écriture et lecture, en particulier une mémoire EEPROM, ou dans lequel dispositif la mémoire (MEM) est une mémoire extractible, en particulier une carte PCMCIA.

4. Dispositif d'enregistrement de la voix selon la revendication 1, sous forme de carte.

5. Dispositif d'enregistrement de la voix selon la revendication 4, dans lequel le dispositif acoustique de sortie (L) est un haut-parleur plan, dans lequel le dispositif de commande est un organe de commande (USE) constitué par des éléments de commande (T), et dans lequel les éléments de commande (T) sont un clavier à effleurement ou un clavier à touches.

6. Procédé d'enregistrement de la voix pour une rédaction consécutive d'un texte correspondant, comprenant les étapes suivantes :
- enregistrement d'une voix parlée à l'aide de moyens acoustiques d'entrée et de sortie,
- numérisation (1) de la voix enregistrée à l'aide d'un convertisseur analogique/numérique et numérique/analogique (AD/DA),
- traitement préalable (2) de la voix numérisée à l'aide d'une extraction de ses caractéristiques, appropriée à une reconnaissance de la voix,
- stockage (3) dans une mémoire (MEM) de la voix numérisée et pré-traitée, et
- lecture (4) des données stockées dans la mémoire (MEM) et transmission (5) des données stockées dans la mémoire (MEM) à l'aide d'un système de transfert de données, par le réseau téléphonique ou un réseau de téléphonie mobile vers un système de traitement de la voix ou un terminal de traitement des données, dans lequel est effectuée la rédaction (6) du texte correspondant à la voix.

7. Procédé selon la revendication 6, dans lequel
- la voix numérisée est codée, parallèlement au traitement préalable et est également stockée en mémoire, et
- après que la voix numérisée et pré-traitée a été transformée en texte correspondant, la voix codée est décodée pour exécuter une correction et est à nouveau transformée en voix analogique, afin de pouvoir effectuer une correction dans un processus de comparaison entre le texte reconnu automatiquement et la voix.
